# EUROPEAN PATENT APPLICATION

(11) **EP 4 050 644 A1**
(43) Date of publication of application: **31.08.2022**
(21) Application number: 21158858.7
(22) Date of filing: 24.02.2021
(51) Int. Cl.: H01L 21/768

(54) **A METHOD FOR FORMING AN INTERCONNECT STRUCTURE**

(71) Applicant: Imec VZW, 3001 Leuven (BE)
(72) Inventor: O´TOOLE, Martin, 3001 Leuven (BE); MURDOCH, Gayle, 3001 Leuven (BE); WECKX, Pieter, 3001 Leuven (BE); TOKEI, Zsolt, 3001 Leuven (BE); RYCKAERT, Julien, 3001 Leuven (BE)
(74) Representative: AWA Sweden AB

(57) **Abstract**

The disclosure relates to a method for forming an interconnect structure, the method comprising:
depositing a conductive layer stack comprising a first and a second conductive layer of different materials, the first conductive layer formed on top of the second conductive layer;
etching a pattern of conductive lines in the conductive layer stack;
forming a via pillar mask on top of a conductive line of said conductive lines; and
etching back the conductive lines using the via pillar mask as an etch mask and the second conductive layer as an etch stop layer, thereby forming underneath the via pillar mask a conductive via pillar in the first conductive layer, the conductive via pillar protruding above etched-back conductive lines.

## Description

### Technical field

The present disclosure relates to a method for forming an interconnect structure.

### Background

State of the art integrated circuits (IC) typically comprise interconnect structures with multiple levels of conductive lines (horizontal interconnect levels "MX") and vias (vertical interconnect levels "VX").

Interconnect structures may be formed in a damascene process, wherein trenches are etched in an inter-layer dielectric (ILD) and then filled with a conductor (e.g. metal) to form lines.

As an alternative to damascene-based approaches, techniques for directly etching conductive lines in a metal layer are being developed. In a "direct metal etch"-approach, conductive lines are instead patterned in a deposited metal layer, e.g. by forming a patterned hardmask on the metal layer and then etching the metal layer using the hardmask as an etch mask. Conductive lines may hence be directly "printed" in a deposited metal layer. The patterned hardmask may be formed using multiple patterning techniques such as self-aligned / spacer-assisted double patterning (SADP) or quadruple patterning (SAQP), enabling tight-pitch hardmask patterns, which subsequently may be directly transferred into a metal layer with a high fidelity.

The line pitches enabled by a direct metal etch-approach however decreases the tolerance for misalignment between a via (e.g. in the VX level) and an underlying conductive line (e.g. in the MX level).

### Summary

In light of the above, it is an objective to address this challenge and provide a method allowing forming of an interconnect structure comprising a conductive line and a via on top, aligned with the conductive line, also for tight pitch line patterns. Further and alternative objectives may be understood from the following.

According to an aspect there is provided a method for forming an interconnect structure, the method comprising:
depositing a conductive layer stack comprising a first and a second conductive layer of different materials, the first conductive layer formed on top of the second conductive layer;
etching a pattern of conductive lines in the conductive layer stack;
forming a via pillar mask on top of a conductive line of said conductive lines; and
etching back the conductive lines using the via pillar mask as an etch mask and the second conductive layer as an etch stop layer, thereby forming underneath the via pillar mask a conductive via pillar in the first conductive layer, the conductive via pillar protruding above etched-back conductive lines.

By the method, the conductive lines may be formed in accordance with a direct metal etch-approach, as described above, by etching conductive lines in the conductive layer stack. The method thus allows forming of tight pitch conductive line patterns. As the conductive via pillar (abbreviated "via pillar" in the following) is formed in the first conductive layer (i.e. of a portion of the first conductive layer preserved underneath the via pillar mask), which forms part of the (initial) conductive line, the via pillar may be self-aligned with respect to a width dimension of the (final etched-back) conductive line.

By using the second conductive layer as an etch stop layer during the etch back of the conductive lines a depth of the etch back may be precisely controlled, such that the via pillar may be formed with a well-defined height on top of the second conductive layer. As may be appreciated, if several via pillars are formed on top of respective conductive lines, this may result in more uniform via pillar heights, in turn enabling a uniform resistance in the interconnect structure.

The use of the second conductive layer as an etch stop layer is enabled by the first and second conductive layers being formed of different materials. This implies that the conductive lines may be etched back using an etching chemistry etching / removing a material of the first conductive layer (first material) at a greater rate than a material of the second conductive layer (second material).

The etch stop function may provide a margin against over-etching the conductive lines which could result in height variability among the etched-back conductive lines. More uniform conductive line heights may further contribute to a reduced resistance variability in the interconnect structure.

The pattern of conductive lines may be etched in the conductive layer stack by etching the conductive layer stack using a patterned hardmask formed on the conductive layer stack as an etch mask.

The via pillar formation is not dependent on presence of hardmask material remaining on the conductive lines after their formation. As a comparative example, the conductive lines could be covered in ILD. A via hole (to be filled with conductive material to form a via) could be formed by first etching the ILD (e.g. through a lithographically defined opening in a mask layer) to down to the hardmask material remaining on the target conductive line. The hardmask material could then be opened selectively to the ILD to complete the via hole formation. The ILD may also be subjected to a chemical mechanical polishing step (CMP) stopping on the hardmask material and then forming the via hole by opening the hardmask material selectively to the ILD. While either of these approaches may allow the via hole to be self-aligned with respect to the target conductive line, it may be challenging to find hardmask material which both allows high fidelity pattern transfer into a metal layer and with respect to which ILD provides a high etch contrast. As an example, silicon nitride and aluminum nitride may be suitable candidate hardmask material for a metal layer etch, however its etch selectivity towards typical ILD materials (e.g. SiO₂) may be insufficient. This may be an increasing issue for tighter pitch patterns and/or increased aspect ratio conductive lines (e.g. height-to-width greater than 3) wherein hardmask thickness may be limited. An insufficient etch selectivity between the hardmask material and the ILD may result in a footprint of the via hole extending outside the target conductive line such that the via may be offset with respect to the target conductive line underneath. This may in turn introduce a resistance variability among different vias of an interconnect structure.

Moreover, the etching of the conductive layer stack and/or the CMP of the ILD may partially consume hardmask material by varying amounts such that hardmask material of varying thickness remains on the conductive lines. For this reason, adopting the approach of the comparative example for forming the via hole may result in via holes, and accordingly vias, of different heights. This could be a further source to resistance variability among different vias

In view of the above, the present method aspect allows hardmask material to be selected e.g. with an aim of facilitating and optimizing the fidelity of the conductive line patterning, without regard to subsequent via formation steps.

As will be set out in the following, the method is compatible with various approaches for forming a via and conductive lines of a further (upper) interconnect level. For example, according to some embodiments the via pillar may form a preliminary via structure acting as a place holder, to be replaced (e.g. at least partially) with a final conductive via. According to some embodiments, the via pillar may function as the via in the final interconnect structure, wherein e.g. a conductive line of the next interconnect level may be formed to enclose the via pillar.

By the term "conductive layer stack" is hereby meant a stack of conductive layers comprising at least the first conductive layer and the second conductive layer. The first conductive layer may be formed of a first metal-comprising material, e.g. a first metal. The second conductive layer may be formed of a second metal-comprising material, e.g. a second metal. The second conductive layer may however also be formed of a metal-comprising hardmask, e.g. a metal nitride.

By the term "on top of" as used in "a first structure on top of a second structure" (e.g. the first conductive layer formed on top of the first conductive layer) is hereby meant that the first structure is formed on and above the second structure, as seen along a vertical direction.

A first structure on top of or on a second structure may be formed directly on the second structure (i.e. in abutment with the second structure) or with an intermediate structure in between.

The term "vertical", e.g. as in "vertical direction" or "vertical orientation", is hereby used to refer to a direction / orientation in relation to (a main plane of extension of) a substrate or a dielectric layer (which may be supported by a substrate) on which the interconnect structure may be formed. That is a vertical direction / orientation refers to a direction / orientation is to be understood as a direction along a normal to a main plane of extension of the substrate / dielectric layer. A "bottom-up direction" is along the vertical direction. A "top-down direction" is against the vertical direction. Vertical qualifiers such as "above", "over", "below", "upper", "top", "bottom", "underlying", "underneath" should accordingly be understood as relative positions along the vertical direction. The term "horizontal", e.g. as in "horizontal direction" or "horizontal orientation" refers to a direction transverse to the vertical direction, e.g. along (a main plane of extension of) the substrate / the dielectric layer on the substrate.

Unless stated otherwise, the term "etching back" in relation to e.g. a layer refers to an etch back of an upper surface of the layer, the etch back thus proceeding along a top-down direction. A top-down etch back may for example be achieved by a directional etching process, such as a vertically biased dry etch, e.g. reactive ion etch (RIE).

According to embodiments, forming the via pillar mask may comprise covering the conductive lines with a mask layer stack and patterning the mask layer stack to form the via pillar mask on top of said conductive line. The via pillar mask may hence be directly patterned / etched in the mask layer stack, e.g. using a lithography and etching process.

The mask layer stack may comprise a process layer embedding the conductive lines, and a mask layer on top of the process layer, and wherein patterning the mask layer stack may comprise patterning the mask layer and then etching back (i.e. in a top-down direction) the process layer while using the patterned mask layer as an etch mask.

A via pillar mask with a small CD may hence be formed with a comparably small number of process steps employing a mask layer stack with a simple composition. The process layer may fill gaps / trenches between the conductive lines, thus accommodating the varying topography created by the conductive lines. The process layer may thus facilitate patterning of the mask layer (e.g. a hardmask layer patterned using lithography and etching). The process layer may be formed as a planarizing layer. The process layer may be a spin-on-layer, e.g. an organic spin-on-layer such as spin-on-carbon (SOC) layer.

The process layer may be etched back such that a thickness portion of the process layer remains between the conductive lines when etching back the conductive lines. The etch back may be stopped at a level below an upper surface of the conductive lines, or when exposing an upper surface of the conductive lines, or the patterned hardmask if present on top of the conductive lines. In either case, the etched back process layer may mask other layers underneath the conductive lines during the conductive line etch back.

It is however also an option to etch back the process layer to a respective bottom surface of the trenches between the conductive lines. The trenches may hence be cleared from the process layer, except where masked.

The via pillar mask may be formed with a width dimension exceeding a linewidth of said conductive line. A linewidth of a conductive line hereby refers to a horizontal dimension of the line, across its longitudinal dimension. In other words, the via pillar mask may overlap (horizontally) trenches at either side of the conductive line. The via pillar mask may hence be defined with a relaxed CD.

According to embodiments, the conductive layer stack may comprise a third conductive layer of a different material than the second conductive layer, wherein the second conductive layer may be formed on top of the third conductive layer. A thickness of the second conductive layer may be smaller than a thickness of each one of the first and the third conductive layer. The etched-back conductive lines may comprise the second conductive layer and the third conductive layer.

The etched-back metal lines may thus be formed comprising the second and third conductive layers, i.e. the second material and a material (third material) of the third conductive layer. In other words, the etched-back conductive lines may comprise conductive lines of the third material capped by thinner conductive lines of the second material. The third material may be selected to enable a low resistance.

Since the second conductive layer is used as an etch stop layer during the conductive line etch back, forming it with a smaller thickness than the first and third conductive layers may reduce a resistance of the via pillar structure. Materials (e.g. metals or metal-comprising materials such as metal nitrides) which may form conductive layers and which may provide sufficient etching stopping power to metal etching chemistries may be less efficient conductors than metals.

The first and third conductive layers may be layers of a same metal. The second conductive layer may be a metal nitride layer. A low resistance via pillar structure and (etched-back) conductive lines may hence be formed. Metal nitrides may provide high etching stopping power to metal etching chemistries. For example, the first and third conductive layers may be Ru-layers and the second conductive layer may be a TiN-layer. A Ru-layer enables low resistance signal routing and allows etching of aggressive pitch line patterns. TiN may be formed as a conductive layer with an ability to withstand a metal etching chemistry such as a Ru-etch.

According to embodiments, at least a major part of a height of the etched-back conductive lines may be formed by the second conductive layer. Hence, the second conductive layer may provide a double function of acting as an etch stop layer during the conductive line etch-back as well as forming a bulk of a cross-sectional dimension of the etched-back conductive lines.

The first and second conductive layers may in this case both be metal layers, albeit of different metals. For example, the first conductive layer may be a Mo-layer and the second conductive layer may be a Ru-layer. The conductive layer stack may for example form a metal bi-layer stack (e.g. of a Mo-layer on top of a Ru-layer).

As mentioned above, the method and embodiments thereof are compatible with various approaches for forming a via and conductive lines of a further (upper) interconnect level. In the following, a first through third approach will be discussed.

According to some embodiments of a first approach, the method may further comprise:
forming a dielectric layer covering the etched-back conductive lines and the conductive via pillar;
reducing a thickness of the dielectric layer and exposing an upper surface of the conductive via pillar;
thereafter etching back the conductive via pillar to form a via hole in the dielectric layer;
depositing conductive material filling the via hole and covering the dielectric layer; and
patterning a further conductive line in the deposited conductive material, the further conductive line extending over the filled via hole.

The via pillar may hence be used as a place holder, allowing a via hole to be etched in a self-aligned manner with respect to the via pillar. The via hole may subsequently be filled with conductive material to form a (final) conductive via integral with the further conductive line.

The etch contrast provided by the second conductive layer with respect to the first conductive layer mitigates a risk of over-etching the via hole into the conductive line underneath the via pillar. This improves control of the depth of the via hole and thus the height of the final via.

The method may further comprise using a varying topography of an upper surface of the deposited conductive material in a region above the via hole as an alignment feature when patterning the further conductive line. Due to the presence of the via hole, the conductive material may form a layer with a varying topography in a region above the via hole. The varying topography may comprise a depression in the upper surface of the deposited conductive material in a region above the via hole.

Prior to forming the dielectric layer, an insulating layer of a different material than the dielectric layer may be deposited over the etched-back conductive lines and the conductive via pillar.

The insulating layer may form a capping on the etched-back conductive lines and (by being of a different material than the dielectric layer) act as a mask for the conductive lines during the step of reducing the thickness of the dielectric layer, and during the step of etching back the conductive via pillar to form a via hole in the dielectric layer. The step of reducing the thickness of the dielectric layer may comprise recessing the dielectric layer using a process adapted to etch / remove a material of the dielectric layer at a greater rate than a material of the insulating layer. The step of etching back the conductive via pillar may comprise etching the conductive via pillar using an etching chemistry etching / removing the first material (of the first conductive layer) at a greater rate than the material of the dielectric layer and the material of the insulating layer, and the material of the dielectric layer at a greater rate than the material of the insulating layer.

The method may further comprise, prior to etching back the conductive via pillar, removing the insulating layer deposited over the conductive via pillar while masking the insulating layer deposited over the etched-back conductive lines. The insulating layer deposited over the etched-back conductive lines may be masked by the (recessed) dielectric layer. The insulating layer may alternatively be masked by a temporary spin-on layer which may be removed after removing the insulating layer from the via pillar.

In case the conductive layer stack comprises the afore-mentioned third conductive layer, the etch back of the conductive via pillar may be stopped at the second conductive layer. Optionally, an additional etch step may be applied to open the second conductive layer and expose the third conductive layer. Hence, lower resistance material of the second conductive layer (e.g. a metal nitride) may avoided in the final via.

In case the conductive layer stack does not comprise the third conductive layer (e.g. a metal bi-layer stack), the etch back of the conductive via pillar may be stopped at the second conductive layer. Hence the via pillar may be completely removed and replaced with the conductive material. Alternatively, the via pillar may be etched back only partially (i.e. only a part of its height).

According to embodiments of a second approach, the method may further comprise:
forming a dielectric layer covering the etched-back conductive lines and the conductive via pillar;
reducing a thickness of the dielectric layer and exposing an upper portion of the conductive via pillar protruding above the dielectric layer;
depositing conductive material on the dielectric layer and the upper portion of the upper conductive via pillar;
patterning a further conductive line in the deposited conductive material, the further conductive line enclosing the upper portion of the conductive via pillar.

This approach facilitates providing a low-resistance interface between the via pillar and the conductive line, as the conductive line may "wrap around" the via pillar.

The method may further comprise using a varying topography of an upper surface of the deposited conductive material in a region above the (protruding) via pillar as an alignment feature when patterning the further conductive line. Due to the protruding via pillar, the conductive material may form a layer with a varying topography in a region above the via pillar. The varying topography may comprise a hill in the upper surface of the deposited conductive material in a region above the via pillar.

Prior to forming the dielectric layer, an insulating layer of a different material than the dielectric layer may be deposited over the etched-back conductive lines and the conductive via pillar.

The insulating layer may form a capping on the etched-back conductive lines and (by being of a different material than the dielectric layer) act as a mask for the conductive lines during the step of reducing the thickness of the dielectric layer. The step of reducing the thickness of the dielectric layer may comprise recessing the dielectric layer using a process adapted to etch / remove a material of the dielectric layer at a greater rate than a material of the insulating layer.

The method may further comprise, prior to depositing the conductive material, removing the insulating layer deposited over the conductive via pillar while masking the insulating layer deposited over the etched-back conductive lines. The insulating layer deposited over the etched-back conductive lines may be masked by the (recessed) dielectric layer. The insulating layer may alternatively be masked by a temporary spin-on layer which may be removed after removing the insulating layer from the via pillar.

According to embodiments of a third approach, the method may further comprise:
forming a dielectric layer covering the etched-back conductive lines and the conductive via pillar;
etching a trench in the dielectric layer exposing an upper portion of the conductive via pillar protruding above a bottom surface of the trench; and
depositing a conductive material filling the trench and enclosing the upper portion of the conductive via pillar.

Further conductive lines may hence be formed in a damascene-style fashion, with its associated advantages. Additionally, this approach facilitates providing a low-resistance interface between the via pillar and the conductive line, as the conductive line may "wrap around" the via pillar.

Prior to forming the dielectric layer, an insulating layer of a different material than the dielectric layer may be deposited over the etched-back conductive lines and the conductive via pillar.

The insulating layer may form a capping on the etched-back conductive lines and (by being of a different material than the dielectric layer) act as a mask for the conductive lines during the step of etching the trench in the dielectric layer. The step of etching the trench may comprise etching the dielectric layer using an etching chemistry etching / removing the material of the dielectric layer at a greater rate than the material of the insulating layer.

The method may further comprise, prior to depositing the conductive material, removing the insulating layer deposited over the conductive via pillar while masking the insulating layer deposited over the etched-back conductive lines. The insulating layer deposited over the etched-back conductive lines may be masked by the (recessed) dielectric layer. The insulating layer may alternatively be masked by a temporary spin-on layer which may be removed after removing the insulating layer from the via pillar.

### Brief description of the drawings

The above, as well as additional objects, features and advantages, may be better understood through the following illustrative and non-limiting detailed description, with reference to the appended drawings. In the drawings like reference numerals will be used for like elements unless stated otherwise.
Figures 1-7 illustrate a method for forming an interconnect structure.
Figures 8-9 illustrate a further method for forming an interconnect structure.
Figures 10-15 illustrate a method for forming a final via and a conductive line of a next interconnect level.
Figures 16-18 illustrate a further method for forming a final via and a conductive line of a next interconnect level.
Figures 19-21 illustrate yet a further method for forming a final via and a conductive line of a next interconnect level.

### Detailed description

The following disclosure relates to methods for forming an interconnect structure suitable for instance for a semiconductor device. The method will be described in connection with forming an interconnect layer above a schematically shown substrate 100. The substrate 100 may be a semiconductor substrate of a conventional type (e.g. a Si-substrate, a Ge-substrate, a SiGe substrate, a silicon-on-insulator substrate etc.) Although not expressly shown, the substrate 100 may support various layers and structures, including e.g. active semiconductor devices such as transistors or passive devices (e.g. formed in front-end of the line), dielectric layers, as well as device-level contacts and any number of interconnect levels (e.g. formed in middle-of the line and/or back-end of line). It will be assumed that the substrate 100 comprises a planar top surface on which conductive lines may be formed as described in the following. As may be appreciated, the planar top surface of the substrate 100 may comprise a planar top surface of a dielectric layer, wherein conductive surfaces (co-planar / flush with the dielectric layer top surface) of structures (e.g. contacts, lines, vias) may be exposed at selected locations to allow for contacting with the conductive lines to be formed. The planar top surface may for example be formed by applying a polishing step (e.g. CMP) to the top surface of the substrate 100.

In the figures, X and Y indicate respectively a first and a second horizontal direction (along the substrate 100) and Z indicates a vertical direction (normal to the substrate 100). The figures show, in perspective, a section of a part of an interconnect structure. The illustrated planes of section extending through the interconnect structure are common to all the figures unless stated otherwise. It is noted that the relative dimensions of the shown elements, in particular the relative thickness of the layers, is merely schematic and may, for the purpose of illustrational clarity, differ from a physical structure.

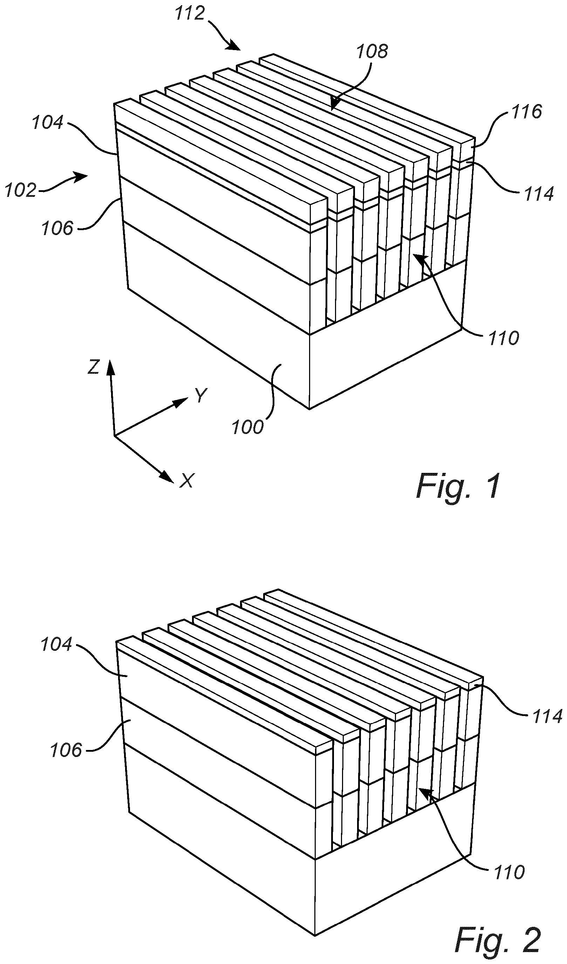

In figure 1, a conductive layer stack 102 has been deposited, e.g. on the planar top surface of the substrate 100, and a pattern of conductive lines 110 has been etched therein. The conductive lines 110 may as shown be patterned such that a longitudinal dimension thereof extends along the X-direction, and to be spaced part along the Y-direction.

The conductive layer stack 102 may as shown comprise a first conductive layer 104 on top of a second conductive layer 106. The first and the second conductive layers 104, 106 are formed of different materials. In the illustrated embodiment it will be assumed that the first and second conductive layers 104, 106 are formed by Mo and Ru, respectively. However, also other conductive materials may be used such as two different metals selected from Mo, Ru, Co, W, Rh and Ir. By way of example, the first and second conductive layers 104, 106 may each be formed with a thickness in a range of 10-100 nm. A thickness of the first conductive layer 104 may be less a thickness of the second conductive layer 106, such as amounting to less than 50% or less than 40% of a combined thickness of the first and second conductive layers 104, 106. The conductive layers 104, 106 may be deposited using any suitable deposition technique such as chemical vapor deposition (CVD), atomic layer deposition (ALD), physical vapor deposition (PVD) or electroplating.

The pattern of conductive lines 110 may be formed by etching the conductive layer stack 102 using a patterned hardmask 112 as an etch mask. Trenches 108 may hence be etched into portions of the conductive layer stack 102 not covered by the patterned hardmask 112. The etching may proceed through the full thickness of the conductive layer stack 102. The trenches 108 may accordingly extend completely through the conductive layer stack 102, in a top-down direction.

The patterned hardmask 112 may be formed on the conductive layer stack 102. The hardmask 112 may as shown comprise a stack of layers, such as a lower hardmask layer 114 (e.g. TiN) and an upper hardmask layer 116 (e.g. SiN). Other hardmask compositions are however also possible such as single-layer hardmasks or hardmask layer stacks of one or more of SiO₂, TiOx, SiCN, AIN.

The one or more hardmask layers (e.g. a TiN layer and a SiN layer) may be deposited on the conductive layer stack 102, e.g. on an upper surface of the first conductive layer 104. Various approaches are possible for patterning the hardmask layer(s) to form the patterned hardmask 112, such as SADP or SAQP. Both Spacer Is Metal (as in SADP-SIM) and Spacer Is Dielectric (as in SADP-SID) are possible. According to SADP-SIM the core/mandrel lines and gap lines may be removed selectively to the spacer lines, wherein the spacer lines may be used as an etch mask when patterning the hardmask layer(s). According to SADP-SID the spacer lines may be removed selectively to core/mandrel lines and the gap lines wherein the core/mandrel lines and the gap lines may be used as an etch mask when patterning the hardmask layer(s). If preserved for the subsequent via pillar formation process, the alternating arrangement of core and gap lines may further facilitate a self-aligned via pillar formation process due to the etch contrast enabled between the core and gap lines (which may be formed of different material).

Such spacer-assisted techniques however only represent examples and other patterning techniques are also possible such as Single Print-Extreme Ultra Violet (EUV), EUV litho-etch-litho-etch (LELE) and self-aligned LELE.

After forming the patterned hardmask 112, the pattern of conductive lines 110 may be etched using e.g. a Reactive Ion Etch (RIE) process or some other conventional etching process enabling high fidelity pattern transfer into a metal layer. The patterning of the conductive lines 110 may comprise using a same etching chemistry for the conductive layers 102, 104 or using different etching chemistries for the conductive layers 102, 104, depending e.g. on the combination of metals.

A feature of the method is that a subsequent via pillar formation does not require hardmask material remaining on the conductive lines 110. Hence, a via pillar may be reliably formed in the disclosed manner even if the hardmask is removed from the conductive lines after forming the conductive lines 110, or partially consumed during the etching of the conducting layer stack 102, such as shown in figure 2 wherein only the lower hardmask layer 114 (e.g. TiN) remains on the conductive lines 110. The method may however proceed in a similar manner as will be disclosed even if the upper hardmask layer 116 (e.g. SiN) would remain, intact or only partially.

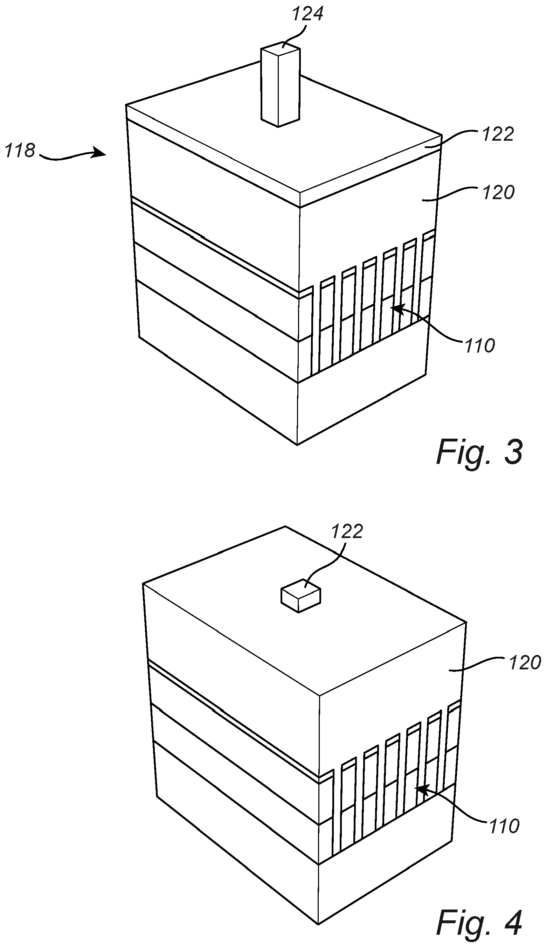

Figures 3-5 depict steps for forming a via pillar mask 130 on top of a conductive line 110a.

As shown in figure 3, the method may proceed by covering the conductive lines 110 with a mask layer stack 118. The mask layer stack 118 may comprise a process layer 120 embedding the conductive lines 110. That is, the process layer 120 may fill the trenches 108 (referenced in figure 1) between the conductive lines 110 and cover the conductive lines 110 (and the patterned hardmask 112 if present). The process layer 120 may be formed as a planarizing process layer 120, i.e. having a planar top surface. The process layer 120 may e.g. be a SOC layer, some other organic spin-on-layer, or a spin-on-oxide (e.g. silicon oxide), allowing the process layer 120 to be directly deposited as a planarizing layer. If needed, a separate planarization step (e.g. CMP) may be applied to the process layer 120 following deposition for improved planarity. The mask layer stack 118 further comprises a mask layer 122 on top of the process layer 120. The mask layer 122 may be formed of a hardmask material such as spin-on-glass or TiN, to provide a few non-limiting examples.

As shown in figures 3-5, the method may proceed by patterning the mask layer stack 118 to form the via pillar mask 130 on top of the conductive line 110a. In figure 3, a mask feature 124 defining a location and horizontal extension of the via pillar mask 130 is formed on the mask layer 122. The mask layer 122 may be covered by a resist layer which may be lithographically patterned to define the mask feature 124.

In figure 4 the mask layer 122 is patterned, i.e. etched, using the mask feature 124 as an etch mask.

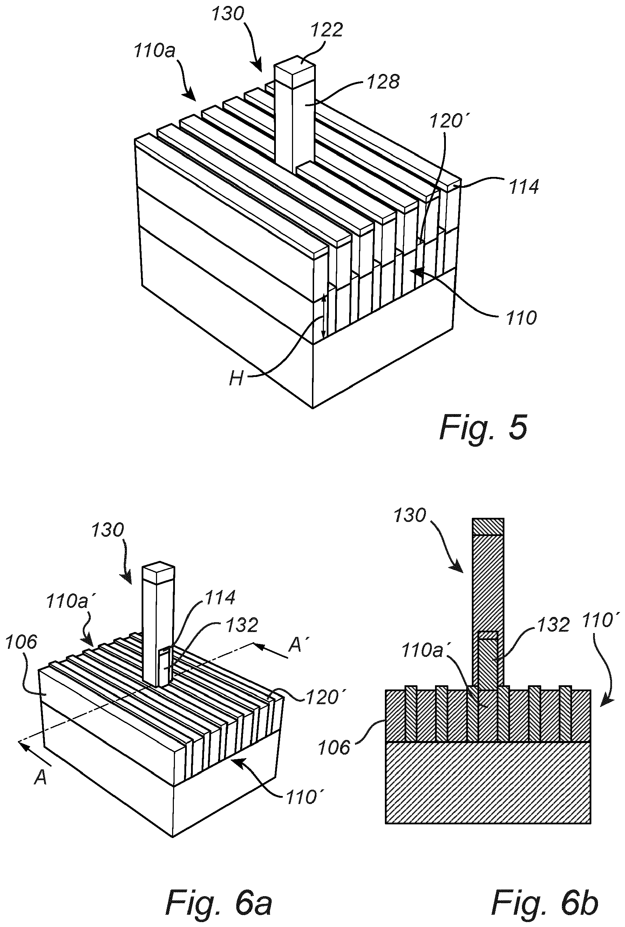

In figure 5, the process layer 120 is patterned, i.e. etched, using the patterned mask layer 122 as an etch mask. The process layer 120 is etched back such that the conductive lines 110 and/or remaining portions of the patterned hardmask 112 are exposed. The via pillar mask 130 may accordingly comprise the (patterned) mask layer 122 and a portion 128 of the process layer 120 (e.g. of SOC) preserved underneath the mask layer 122. The mask feature 124 may be consumed during the etching of the process layer 120, or stripped from the patterned mask layer 122 before or after etching back the process layer 120.

The process layer 120 may as shown be etched back such that a thickness portion 120' of the process layer 120 remains between the conductive lines 110. That is, the etch back may be stopped before reaching a respective bottom of the trenches 108 in the conductive layer stack 102. The thickness portion 120' may mask other layers underneath the conductive layer stack 102 during a subsequent conductive line etch back. The thickness H of the remaining thickness portion 120' may be a compromise between the additional time required for continuing the etch back into the trenches 108, and the faster etch back of the conductive lines 110 allowed when not surrounded by the process layer 120' on either sides.

As indicated in figure 5, the via pillar mask 130 may be formed with a width dimension (as seen along the Y-direction) of the via pillar mask 130 exceeding a linewidth (as seen along the Y-direction) of the conductive line 110a. This may be achieved by lithographically patterning the mask feature 124 with a relaxed CD, i.e. exceeding the final intended width dimension of the conductive via pillar to be formed.

Figures 3-5 show formation of a single via pillar mask 130, however any number of via pillar masks may be formed in parallel, e.g. by patterning the mask layer 122 into a corresponding number of mask layer portions on top of a number of the conductive lines 110.

Other approaches for forming the via pillar mask 130 are also possible. Generally, any sequence of lithography and etching steps (a LE sequence) allowing patterning of a via pillar mask feature in a mask layer stack may be used. For example, a mask layer stack with a greater number of layers may be used, such as comprising additional hardmask layers and/or anti-reflective coatings above a planarizing layer (e.g. of SOC). It is also contemplated that a via pillar mask may be formed in a tone-inverted approach. A hole may be patterned in a sacrificial layer covering the conductive lines, at an intended location for the via pillar mask. The hole may be filled with a mask material wherein the sacrificial layer may be removed (by selective etching) such that the mask material remains to form the via pillar mask.

Figure 6b shows a cross-section of the interconnect structure taken along line A-A' indicated in figure 6a. In figures 6a and 6b the conductive lines 110 have been etched back using the via pillar mask 130 as an etch mask. The etch back is stopped on the second conductive layer 106, which accordingly is used as an etch stop layer. A conductive via pillar 132 has thereby been formed by a portion of the first conductive layer 104 masked by the via pillar mask 130 during the etch back. The via pillar 132 protrudes above the etched-back conductive lines 110' (i.e. along the Z direction). As the etch back is stopped on the second conductive layer 104, a bulk of a cross-sectional dimension of the etched-back conductive lines 110' may be formed by the second conductive layer 104.

For example, a first conductive layer 104 of Mo may be etched selectively to a second conductive layer 106 of Ru using CF₄, CHF₃, BCl₃, CF₂Cl₂, or Br₂. The etch back of the conductive lines 110 may be preceded by an etch step of opening any remaining hardmask (e.g. layer 114) capping the conductive lines 110.

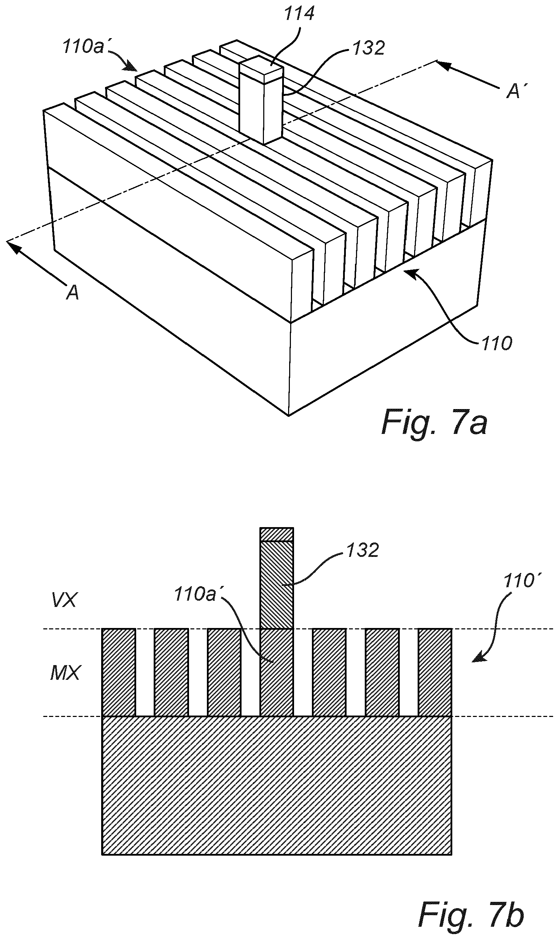

In figures 7a and 7b (views corresponding to figures 6a and 6b), the via pillar mask 130 has been removed from the interconnect structure, together with the remaining thickness portions 120' of the process layer 120, e.g. using a suitable isotropic wet etching chemistry. As shown in figure 7b, the etched-back conductive lines 110' may be formed in a horizontal interconnect level MX, while the conductive via pillar 132 may be formed in a vertical interconnect level VX.

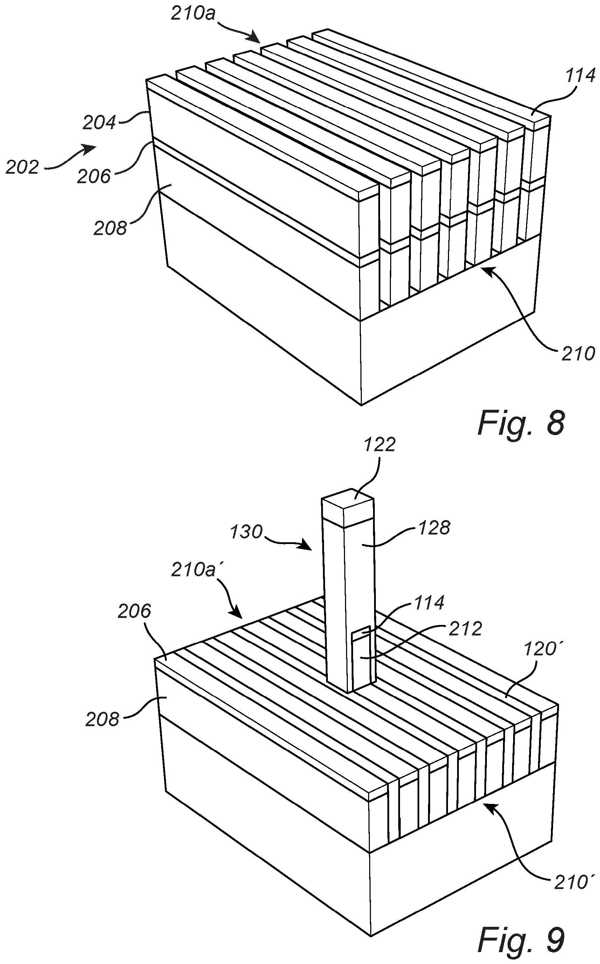

Figures 8 and 9 illustrate patterning of conductive lines 210 in a conductive layer stack 202 of another composition, and forming a conductive via pillar 212 protruding above etched-back conductive lines 210', according to an alternative embodiment. The layer stack 202 comprises first through third conductive layers 204, 206, 208, the second conductive layer 206 formed on top of the third conductive layer 208 and the first conductive layer 204 formed on top of the second conductive layer 206. The second conductive layer 206 is formed of a material different from each of the first and third conductive layers 204, 208. In the illustrated embodiment it will be assumed that the first, second and third conductive layers 204, 206, 208 are formed by Ru, TiN and Ru, respectively. However, it is envisaged that also other conductive first, second and third conductive materials may be possible such as a metal nitride or intermetallic layer 206 (e.g. TiN, AIN, or an aluminum intermetallic like Al3Sc) between two metal layers 204, 208 of a same or different metal (e.g. Al, Ti, Ru, Mo, Co, W, Rh or Ir). The stack 202 may also comprise a metal layer 206 selected as a metal different from the metal layers 204, 208, e.g. a Mo-layer 206 between two Ru-layers 204, 208 or vice versa as two non-limiting examples. The first, second and third conductive layers 204, 206, 208 may be deposited using e.g. any suitable deposition techniques mentioned in connection with the conductive layers 104, 106.

According to the illustrated embodiment, the second conductive layer 206 may, like the second conductive layer 106 of the illustrated embodiment discussed above, provide a function of acting as an etch stop layer during an etch back of the conductive lines 210. However, in contrast to the second conductive layer 106, the second conductive layer 206 may provide only a minority contribution to the cross-sectional dimension of the etched-back conductive lines 210', a bulk thereof instead being provided by the third conductive layer 208 (e.g. which may be a metal layer of low resistance). The second conductive layer 206 may be formed with a smaller thickness than the third conductive layer 208, and also than the first conductive layer 204. The etched-back conductive lines 210' may comprise conductive lines of the third conductive layer 208 / third material capped by conductive lines of the second conductive layer 206 / second material. A thickness of the second conductive layer 206 may for example amount to 10% or less, or 5% or less, of a combined thickness of the first, second and third conductive layers 204, 206, 208. By way of example, the first, second and third conductive layers 204, 206, 208 may be formed with thicknesses in a range of 10-100 nm, 1-5 nm and 10-30 nm, respectively.

The method may proceed in a similar manner as described in connection with figures 1-5, by etching a pattern of conductive lines 210 in the conductive layer stack 202 (e.g. using a patterned hardmask 112 as an etch mask), forming a via pillar mask 130, and subsequently etching back the conductive lines 210 using the via pillar mask 130 as an etch mask and the second conductive layer 206 as an etch stop layer. Thereby, the conductive via pillar 212 may be formed (e.g. by a portion of the first conductive layer 204 masked by the via pillar mask 130 during the etch back) protruding above the etched-back conductive lines 210'. For example in a stack of Ru/TiN/Ru, Ru may be etched selectively to TiN using O₂. In a stack of Mo/TiN/Mo, Mo may be etched selectively to TiN using Br₂. The via pillar mask 130 may subsequently be removed from the interconnect structure, together with the remaining process layer thickness portions 120'.

According to embodiments, the method may comprise further steps which may be applied e.g. to the interconnect structure shown in figures 7a-7b to replace the via pillar 132 (partially or in full) with a final via (e.g. in level VX) and forming a further conductive line of a next interconnect level (e.g. in level MX+1) connected to the final via.

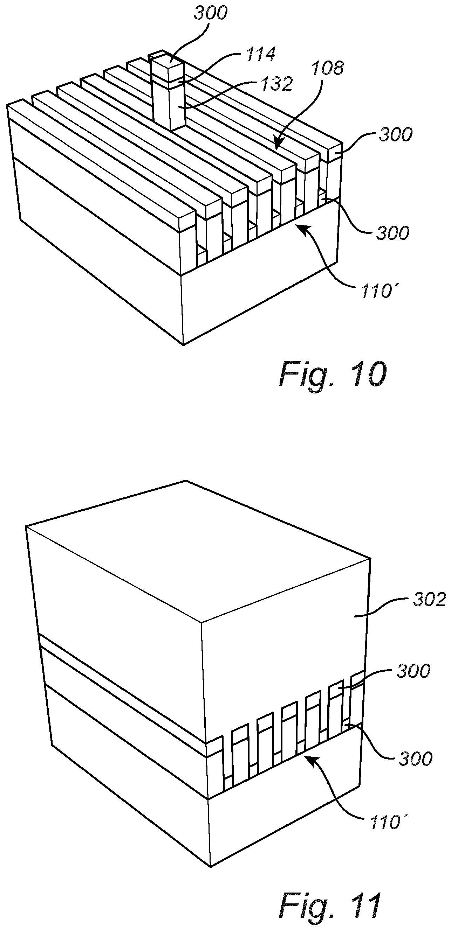

In figure 10, an optional insulating layer 300 has been deposited over the etched-back conductive lines 110' and the conductive via pillar 132 shown in figures 7a-7b. The insulating layer 300 may be formed by an insulating material different from an ILD deposited in figure 11, e.g. a nitride material such as SiN or AIN. Other possible nitride materials are carbon-nitrides such as SiCN and oxy-nitrides such as AION. A thickness of the insulating layer 300 may be less than a height of the etched-back conductive lines 110', such that the insulating layer 300 is formed in only a lower part of the trenches 108 between the conductive lines 110'. The insulating layer 300 may be deposited in a top-down direction using a non-conformal deposition technique, such as CVD or PVD. Depending on the pitch of the conductive line pattern and the depth of the trenches 108, the insulating layer 300 may cause pinch-off of the trenches 108 such that air gaps are formed in the trenches 108 underneath pinch-off. It is to be understood that the insulating layer 300 however is an optional layer and that the method may proceed without it.

In figure 11 a dielectric layer 302 covering the etched-back conductive lines 110' and the conductive via pillar 132 has been formed. The dielectric layer 302 may be formed of a conventional ILD material, such as SiO₂ or a low-k flowable CVD oxide.

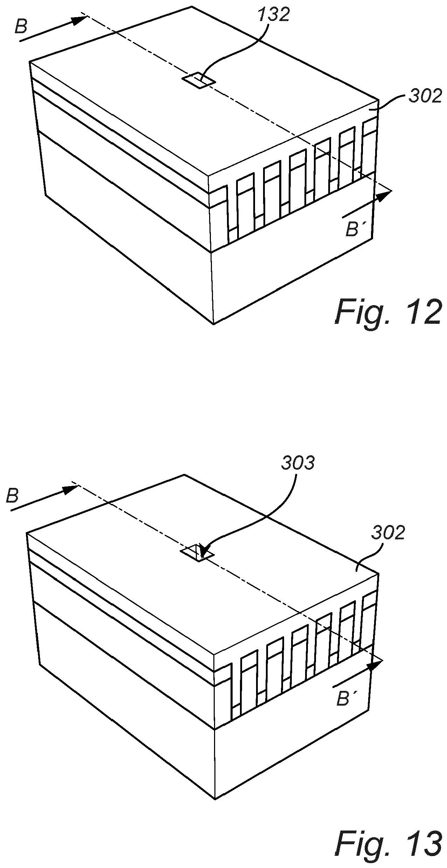

In figure 12, a thickness of the dielectric layer 302 has been reduced and an upper surface of the conductive via pillar 132 has been exposed. A polishing step (e.g. CMP) may be applied to a top surface of the dielectric layer 302 until the upper surface of the conductive via pillar 132 is exposed in the dielectric layer 302 of reduced thickness. The dielectric layer 302 may hence be formed with a planar top surface, co-planar with the upper surface of the conductive via pillar 132. Other process techniques may include a combination of an initial polishing step followed by dielectric layer etch back. In any case, exposing the upper surface of the conductive via pillar 132 may comprise removing the (optional) insulating layer 300 and/or hardmask material 114 from the conductive via pillar 132 (if still present).

In figure 13, the upper surface of the conductive via pillar 132 has been etched back (top-down) to form a via hole 303 in the dielectric layer 302 of reduced thickness. Any suitable etching process (wet or dry) allowing the metal of the via pillar 132 (i.e. of the first conductive layer 104) to be etched selectively to the dielectric layer 302 may be used. The insulating layer 302 may during the etch back of the via pillar 132 act as a mask for the conductive lines 110', including the conductive line 110a' underneath the via pillar 132. The insulating layer 302 may accordingly provide an increased mask budget for the conductive lines 110' during the etch back of the via pillar 132. This may further facilitate self-aligned formation of the via hole 303 with respect to the via pillar 132 along the X-direction, e.g. if a sufficient mask budget of the dielectric layer 302 with respect to the (metal) etch back of the via pillar 132 cannot be ensured.

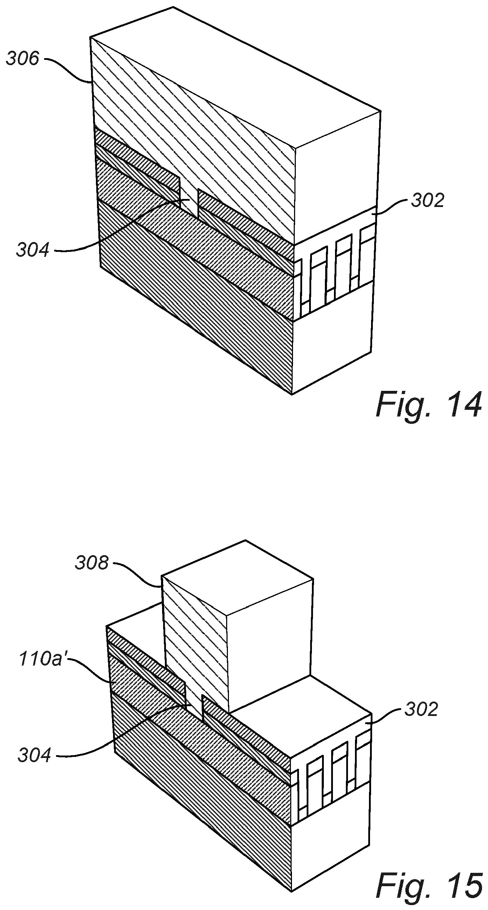

Figure 14 shows a cross-section of the interconnect structure taken along the line B-B' indicated in figure 13. As shown, a conductive material 306 has been deposited in the shape of a layer, filling the via hole 303 and covering the dielectric layer 302. A final via (pillar) 304 has hence been formed on top of the conductive line 110'. Examples of conductive materials 306 include Ru, Mo, Co, W, Rh, Ir and intermetallics (e.g. an aluminum intermetallic) deposited e.g. by CVD, ALD, PVD or electroplating. The conductive material 306 may be a single metal of the aforementioned materials, or comprise a combination of two or more metals.

Figure 15 shows a corresponding cross-section of the interconnect structure along the line B-B' wherein a further conductive line 308 has been patterned in the deposited conductive material 306. The further conductive line 308 is aligned with the via hole 303 such that the line 306 extends over and contacts the via 304 in the via hole 303. The via 304 may accordingly extend (e.g. through the VX level) between the conductive line 110a' (e.g. of the MX level) to the further conductive line 308 (e.g. of the MX+1 level).

Depending on the amount of etch back applied to the conductive via pillar 132 in figure 13, the final via 304 may (if the etch back proceeds until the second conductive layer 106 acting as an etch stop layer) comprise only the conductive material 306, or (if the etch back only is partial) a combination of remaining material of a partially etched back via pillar structure 132 and the conductive material 306.

The conductive line 308 may as shown be patterned such that a longitudinal dimension thereof extends along the Y-direction. Although figure 15 only shows a single conductive line 308 a plurality of conductive lines may be patterned simultaneously in the conductive material 306, e.g. to be spaced part along the X-direction.

As indicated in figure 15, a linewidth of the further conductive line 308 may exceed a linewidth of the conductive lines 110'. This may reduce a resistance of the conductive line 308 and also facilitate horizontally aligning the conductive line 308 with the via 304. Accordingly a "tight pitch" interconnect level MX may be combined with a "relaxed pitch" interconnect level MX+1.

Although not visible in figures 14 and 15, due to the presence of the via hole 303, the layer of conductive material 306 may present a varying topography in a region above the via hole 303, e.g. in the form of a depression in the upper surface of the deposited conductive material in a region above the via hole 303. The varying topography may be used as an alignment feature to facilitate the patterning of the conducive line 308.

According to embodiments, the via pillar 132 may alternatively form a via in the final interconnect structure and accordingly not be replaced as disclosed above.

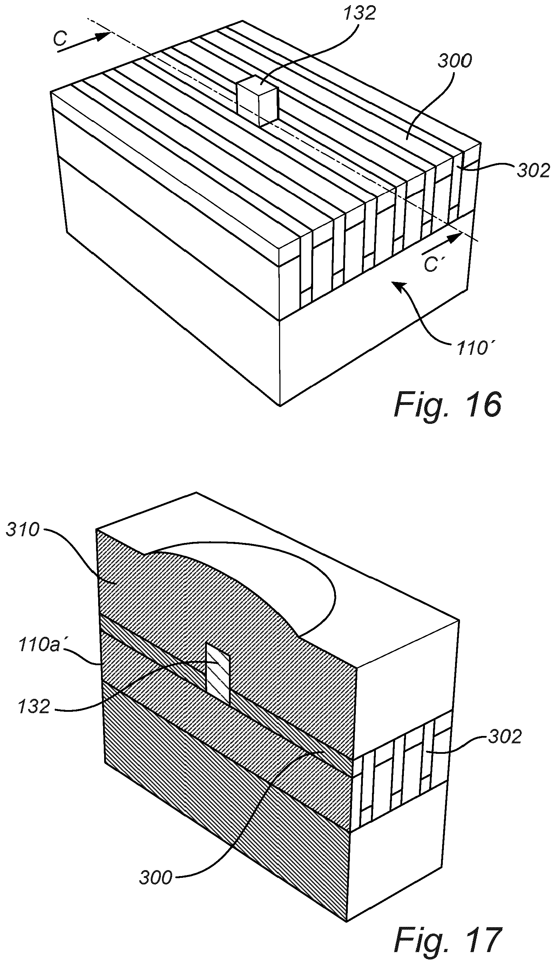

An embodiment of such an alternative approach may initially proceed as shown in figures 11-13, by depositing the insulating layer 300 (optional), forming the dielectric layer 302 and reducing a thickness of the dielectric layer 302 and exposing an upper portion of the via pillar 132. As shown in figure 16, the method may then depart from the previous approach in that a thickness of the dielectric layer 302 may be further reduced such that an upper portion of the via pillar 132 protrudes above the dielectric layer 302. This may be provided by a greater (chemical) selectivity of the CMP towards the dielectric layer 302 than the metal of the via pillar 132, or by applying a separate dielectric etch back step to the dielectric layer 302 after the upper surface of the via pillar 132 has been exposed.

The (further) thickness reduction may as shown be stopped on the insulating layer 300. If no insulating layer 300 which may act as an etch stop layer on top of the conductive lines 110' is present, the thickness reduction may be stopped such that the dielectric layer 302 has a remaining thickness sufficient to ensure electrical insulating between the lines of the MX and MX+1 levels.

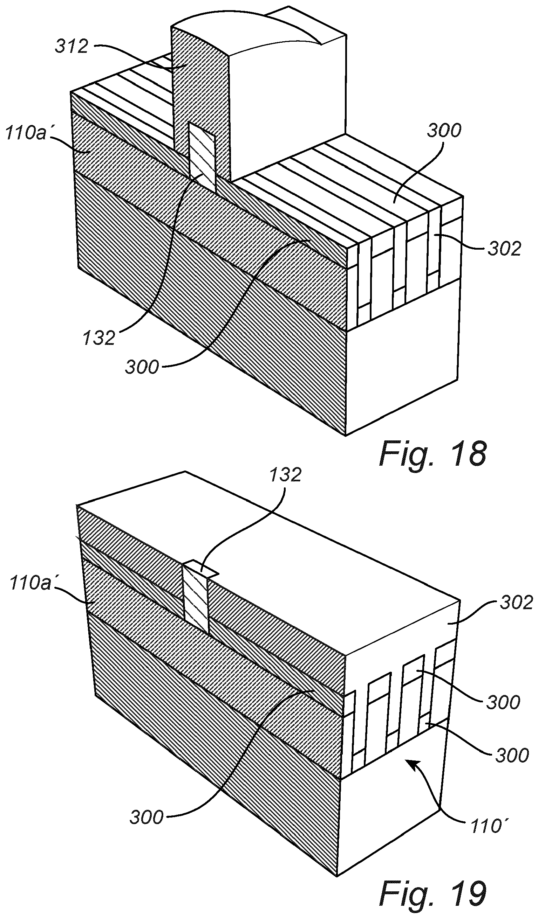

The method may then proceed as shown in figures 17 and 18 (each showing cross-sections of the interconnect structure taken along the line C-C' indicated in figure 16) by depositing conductive material 310 on the dielectric layer 302 and the upper portion of the upper conductive via pillar 132 (figure 17) and patterning a further conductive line 312 (e.g. of the MX+1 level) in the deposited conductive material 310. The further conductive line 312 may be patterned to enclose the upper portion of the via pillar 132. The further conductive line 312 may as shown be patterned to extend along the Y-direction. The discussion of the conductive material 306 and further conductive line 308 otherwise applies to the material 310 and line 312.

Due to the presence of the protruding via pillar 312, the layer of conductive material 310 may present a varying topography in a region above the via hole 303, e.g. in the form of a hill-shaped feature in a region above the via hole 303. The varying topography may be used as an alignment feature to facilitate the patterning of the conductive line 312.

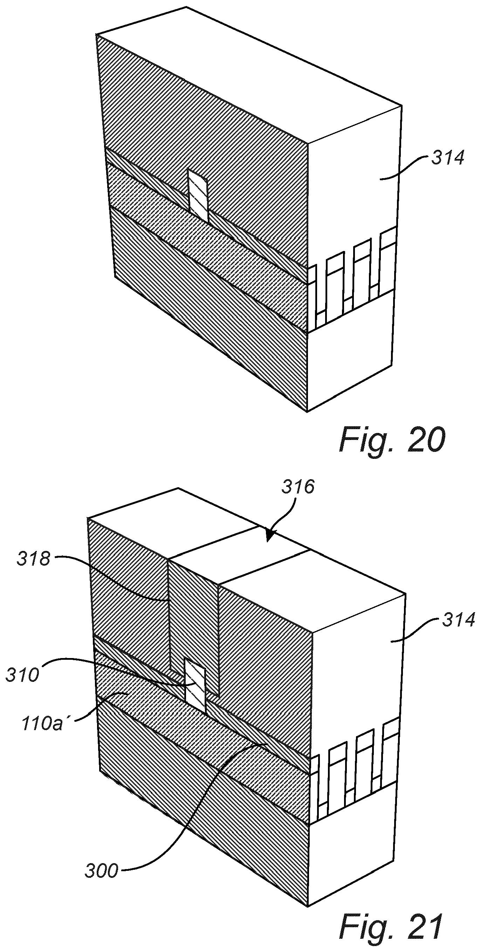

An embodiment of a further alternative approach may initially proceed as shown in figures 11-12 by depositing the insulating layer 300 (optional), forming the dielectric layer 302 and reducing a thickness of the dielectric layer 302 and exposing an upper portion of the via pillar 132. Figure 19 shows a cross-section of the resulting interconnect structure taken along line B-B' indicated in figure 12. The method may then depart from the previous approaches in that dielectric material (e.g. of a same ILD material as the layer 302) may be re-deposited to form a dielectric layer 314 covering the via pillar 132, as shown in figure 20.

As shown in figure 21, a trench 316 may then be etched in the dielectric layer 314. The trench 316 may be etched to expose an upper portion of the conductive via pillar 132 protruding above a bottom surface of the trench 316. One or more conductive materials (commonly referenced 318), such as a liner layer (e.g. a metal-nitride layer deposited by ALD) and a conductive fill metal layer (e.g. Ru, Al or W deposited by CVD, PVD or electroplating) may then be deposited to fill the trench 316. The deposited conductive material may accordingly be deposited on the upper portion of the conductive via pillar 132 and enclose the same.

The conductive material 318 may be deposited to form an overburden on a top surface of the dielectric layer 314. The overburden may be removed by a polishing step (e.g. CMP) and/or metal etch back to expose the dielectric layer 314, thereby arriving at the structure depicted in figure 21 comprising a further conductive line (e.g. of the MX+1 level) comprising the conductive material 318 deposited in the trench.

The trench 316 may as shown be patterned such that a longitudinal dimension thereof extends along the Y-direction. Accordingly, also a longitudinal dimension of the further conductive line may extend along the Y-direction. Although figure 21 only shows a single trench 316 a plurality of trenches 316 may be patterned simultaneously in the dielectric layer 314, wherein a plurality of further conductive lines may be formed in the trenches.

The insulating layer 302 may during etching of the trench 316 act as a mask for the conductive lines 110', including the conductive line 110a' underneath the via pillar 132. The insulating layer 302 may accordingly provide an increased mask budget for the conductive lines 110' during the etching of the trench 316. The insulating layer 302 may for example be used as an etch stop layer for the trench etch. The insulating layer 302 may facilitate ensuring a sufficient isolation between the conductive lines 110' and the further conductive lines (e.g. of the MX+1 level), e.g. if a sufficient thickness portion of the dielectric layer 302 underneath the trench 316 cannot be ensured.

It is contemplated that the above process steps may be repeated a number of times to form a further "tight pitch" MX+2 interconnect level and a further "relaxed pitch" interconnect level MX+3. Vias of a VX+2 interconnect level between MX+2 and MX+3 may be formed in accordance with either of the embodiments shown in figures 10-15, 16-18 or 19-21. The MX+1 and MX+2 interconnect levels may be interconnected by vias in a VX+1 level, e.g. formed by depositing metal in via holes etched in an ILD covering the MX+1 level (similar to a damascene-approach).

As disclosed above, the portion of the insulating layer 300 deposited on the via pillar 132 may be removed in connection with the CMP and/or etch-back of the dielectric layer 302. In an alternative approach, the deposition of the insulating layer 330 may be followed by forming of a temporary layer (e.g. SOC or other spin-on-layer) covering the portions of the insulating layer 300 deposited on the conductive lines 110' and exposing the portion of the insulating layer 300 on the via pillar 132. The insulating layer 300 may then be removed from the via pillar 132 while the temporary layer masks the insulating layer 300 on the conductive lines 110'. The temporary layer may then be removed to expose the insulating layer 300 remaining on the conductive lines 110'. The method may then proceed by depositing the dielectric layer 302, as discused above.

According to embodiments, the approaches shown in figures 10-15, 16-18 or 19-21 may also be applied to the interconnect structure depicted in figure 9 in a corresponding manner as set out above. However, following the approach of figures 10-15, the method may proceed as set out above by depositing the (optional) insulating layer 300 over the etched-back conductive lines 210' and the via pillar 212, forming the dielectric layer 302 and reducing a thickness of the dielectric layer 302 and exposing an upper portion of the via pillar 212 (e.g. of a metal such as Ru). The via pillar 212 may then be etched-back to form a via hole 303 in the dielectric layer 302. The etch-back may be partial (stopping within the via pillar 212) or complete (stopping on the second conductive layer 206). Optionally, an additional etch step may then be applied to open the second conductive layer 206 (e.g. of a metal nitride such as TiN) and expose the third conductive layer 208 underneath (e.g. of a metal such as Ru). Hence, lower resistance material of the second conductive layer (e.g. a metal nitride) may be removed such that at final via 304 may be formed only by metal.

In the above the inventive concept has mainly been described with reference to a limited number of examples and embodiments. However, as is readily appreciated by a person skilled in the art, other examples and embodiments than the ones disclosed above are equally possible within the scope of the inventive concept, as defined by the appended claims.

## Claims

1. A method for forming an interconnect structure, the method comprising:
depositing a conductive layer stack (102) comprising a first and a second conductive layer (104, 106; 204, 206) of different materials, the first conductive layer (104) formed on top of the second conductive layer (106);
etching a pattern of conductive lines (110, 210) in the conductive layer stack (102, 202);
forming a via pillar mask (130) on top of a conductive line (110a, 210a) of said conductive lines (110, 210); and
etching back the conductive lines (110, 210) using the via pillar mask (130) as an etch mask and the second conductive layer (106; 206) as an etch stop layer, thereby forming underneath the via pillar mask (130) a conductive via pillar (132; 212) in the first conductive layer (104; 204), the conductive via pillar (132; 212) protruding above etched-back conductive lines (110'; 210').

2. A method according to claim 1, wherein forming the via pillar mask (130) comprises covering the conductive lines (110) with a mask layer stack (118) and patterning the mask layer stack (118) to form the via pillar mask (130) on top of said conductive line (110a).

3. A method according to claim 2, wherein the mask layer stack (118) comprises a process layer (120) embedding the conductive lines (110), and a mask layer (122) on top of the process layer (120), and wherein patterning the mask layer stack (118) comprises patterning the mask layer (122) and then etching back the process layer (120) while using the patterned mask layer (122) as an etch mask.

4. A method according to claim 3, wherein the process layer (120) is etched back such that a thickness portion of the process layer (120) remains between the conductive lines (110) when etching back the conductive lines (110).

5. A method according to any one of the preceding claims, wherein a width dimension of the via pillar mask (130) exceeds a linewidth of said conductive line (110a).

6. A method according to any one of claims 1-5, wherein the conductive layer stack (202) comprises a third conductive layer (208) of a different material than the second conductive layer (206), the second conductive layer (206) being formed on top of the third conductive layer (208), wherein a thickness of the second conductive layer (206) is smaller than a thickness of each one of the first and the third conductive layer (204, 208), and wherein the etched-back conductive lines (210') comprises the second conductive layer (206) and the third conductive layer (204).

7. A method according to claim 6, wherein the first and third conductive layers (204, 208) are of a same metal and the second conductive layer (206) is a metal nitride layer.

8. A method according to any one of claims 1-5, wherein at least a major part of a height of the etched-back conductive lines (110') is formed by the second conductive layer (106).

9. A method according to claim 8, wherein the first and second conductive layers (104, 106) are metal layers.

10. A method according to any one of claims 1-9, further comprising:
forming a dielectric layer (302) covering the etched-back conductive lines (110') and the conductive via pillar (132);
reducing a thickness of the dielectric layer (302) and exposing an upper surface of the conductive via pillar (132);
thereafter etching back the conductive via pillar (132) to form a via hole (303) in the dielectric layer (302);
depositing conductive material (306) filling the via hole (303) and covering the dielectric layer (302); and
patterning a further conductive line (308) in the deposited conductive material (306), the further conductive line (308) extending over the filled via hole (303).

11. A method according to claim 10, wherein the etching back of the conductive via pillar (132) is stopped at the second conductive layer (106, 206) and/or the third conductive layer (208).

12. A method according to any one of claims 1-9, further comprising:
forming a dielectric layer (302) covering the etched-back conductive lines (110') and the conductive via pillar (132);
reducing a thickness of the dielectric layer (302) and exposing an upper portion of the conductive via pillar (132) protruding above the dielectric layer (302);
depositing conductive material (310) on the dielectric layer (202) and the upper portion of the upper conductive via pillar (132);
patterning a further conductive line (312) in the deposited conductive material (310), the further conductive line (312) enclosing the upper portion of the conductive via pillar (132).

13. A method according to any one of claims 1-9, further comprising:
forming a dielectric layer (314) covering the etched-back conductive lines (110') and the conductive via pillar (132);
etching a trench (316) in the dielectric layer (314) exposing an upper portion of the conductive via pillar (132) protruding above a bottom surface of the trench (316); and
depositing a conductive material (318) filling the trench (316) and enclosing the upper portion of the conductive via pillar (132).

14. A method according to any one of claims 10-13, wherein, prior to forming the dielectric layer (302, 314), an insulating layer (300) of a different material than the dielectric layer (302, 314) is deposited over the etched-back conductive lines (110') and the conductive via pillar (132), the insulating layer (300) forming a capping on the etched-back conductive lines (110') masking the etched-back conductive lines (110') during the step of reducing the thickness of the dielectric layer (302) or the step of etching the trench (316) in the dielectric layer (314).

15. A method according to claim 14, the method further comprising, prior to depositing the conductive material (306; 308; 318, 320), removing the insulating layer (300) deposited over the conductive via pillar (132) while masking the insulating layer (300) deposited over the etched-back conductive lines (110').
